(19) Europäisches Patentamt

European Patent Office

Office européen des brevets

(11) **EP 3 117 228 B1**

(12) **EUROPÄISCHE PATENTSCHRIFT**

(45) Veröffentlichungstag und Bekanntmachung des Hinweises auf die Patenterteilung:
**03.01.2018 Patentblatt 2018/01**

(21) Anmeldenummer: **15711086.7**

(22) Anmeldetag: **10.03.2015**

(51) Int Cl.:
*G01R 31/36* (2006.01)     *G01R 31/28* (2006.01)

(86) Internationale Anmeldenummer:
**PCT/EP2015/054927**

(87) Internationale Veröffentlichungsnummer:
**WO 2015/135922 (17.09.2015 Gazette 2015/37)**

(54) **ENERGIESPEICHEREMULATOR UND VERFAHREN ZUR EMULATION EINES ENERGIESPEICHERS**

ENERGY ACCUMULATOR EMULATOR AND METHOD FOR EMULATION OF AN ENERGY ACCUMULATOR

ÉMULATEUR D'ACCUMULATEUR D'ÉNERGIE ET PROCÉDÉ D'ÉMULATION D'UN ACCUMULATEUR D'ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.03.2014 AT 501872014**

(43) Veröffentlichungstag der Anmeldung:
**18.01.2017 Patentblatt 2017/03**

(73) Patentinhaber: **AVL List GmbH**
**8020 Graz (AT)**

(72) Erfinder: **SCHIPFER, Gottfried**
**A-8521 Wettmannstätten (AT)**

(74) Vertreter: **Patentanwälte Pinter & Weiss OG**
**Prinz-Eugen-Straße 70**
**1040 Wien (AT)**

(56) Entgegenhaltungen:
**WO-A1-2006/054066      JP-A- 2012 047 715**
**US-A1- 2012 150 503**

- **YONGJUN YUAN ET AL: "Assessment of power consumption control strategy for battery management system using hardware-in-the-loop simulation", VEHICLE POWER AND PROPULSION CONFERENCE, 2008. VPPC '08. IEEE, IEEE, PISCATAWAY, NJ, USA, 3. September 2008 (2008-09-03), Seiten 1-6, XP031363165, DOI: 10.1109/VPPC.2008.4677485 ISBN: 978-1-4244-1848-0**

**Beschreibung**

Die gegenständliche Erfindung betrifft einen Energiespeicheremulator mit einem Energiespeichermodell zur Emulation eines elektrischen Energiespeichers bestehend aus einer Anzahl von Zellen und mit zumindest einer realen Referenzzelle, die über einen Zelltester mit dem Energiespeicheremulator verbunden ist, sowie ein Verfahren zur Emulation eines Energiespeichers.

In der Entwicklung von elektrischen Energiespeichern, insbesondere von Traktionsbatterien oder Batteriepacks für Hybrid- oder Elektrofahrzeuge, spielen Energiespeicheremulatoren, die das reale Verhalten eines Energiespeichers nachbildet, eine große Rolle. Solche Energiespeicher sind sehr teuer, weshalb es vorteilhaft ist, den Energiespeicher zu emulieren und die Entwicklungsarbeit bzw. Tests an der Emulation durchzuführen. Ein Energiespeicheremulator umfasst dabei ein Energiespeichermodell, das aus einer Leistungsanforderung, z.B. einem gewünschten Strom, die Ausgangsspannung einstellt, die sich dabei bei der realen Batterie einstellen würde. Je nach Komplexität des Energiespeichermodells können verschiedene Einflussgrößen berücksichtigt werden, wie z.B. Last, Temperatur, Ladezustand (SoC - State of Charge), Batteriechemie, etc. Ein solcher Energiespeicheremulator geht z.B. aus der AT 510 998 A2 hervor.

Für jeden Energiespeicher kann es je nach geforderter Genauigkeit unterschiedliche Energiespeichermodelle geben. Daneben gibt es noch verschiedene Batterietypen, wie z.B. LiIon- oder LiFePO4-Batterie, die ebenfalls unterschiedliche Energiespeichermodelle bedingen. Weiters kann ein Energiespeicher auf Zell-, Modul- (Einheit aus mehreren Zellen) oder Packebene (Einheit aus mehreren Modulen) modelliert werden. Und nicht zuletzt kann jedes Energiespeichermodell auch noch unterschiedlich parametrisiert werden. In der Praxis ist daher der Aufwand für die Energiespeichermodellbildung und die Parametrisierung eines Energiespeichermodells sehr hoch. Abgesehen davon liefert ein Energiespeichermodell in der Regel nicht über den gesamten Betriebsbereich der Batterie Ausgangsgrößen gleich guter Qualität. Es ist daher unter Umständen auch notwendig, das Energiespeichermodell vor bzw. sogar während einer Emulation nachzukalibrieren oder zu wechseln, um es an einen bestimmten Betriebsbereich anzupassen. Beim Kalibrieren werden in der Regel die Modellparameter des Energiespeichermodells angepasst. Der Zeitpunkt wann das Energiespeichermodell nachkalibriert oder gewechselt werden soll ist aber im Vorfeld nur schwierig festzulegen, da die Qualität des Energiespeichermodells auch noch von anderen Einflussgrößen, wie z.B. SoC, Temperatur, beeinflusst wird.

In der JP 2012-047715 A ist ein Energiespeicheremulator beschrieben, bei dem eine reale Referenzzelle, oder eine reale Referenzzellengruppe, verwendet wird, um das Spannungsverhalten der realen Zelle zu erfassen. Das Spannungsverhalten der einzelnen Zelle wird dann auf die Vielzahl der Zellen einer realen Batterie hochgerechnet, um das Spannungsverhalten der ganzen Batterie zu ermitteln. Diese Batteriespannung wird von einer Spannungsquelle erzeugt und an eine elektrische Last geschaltet. Damit kann eine ganze Batterie anhand einer einzelnen realen Referenzzelle emuliert werden. Die emulierte Batterie besteht damit aber immer aus gleichen Zellen, was in der Realität aber normalerweise nicht der Fall ist. Unterschiedliche Zellzustände lassen sich auf diese Weise nicht emulieren, was die Emulationsmöglichkeiten doch einschränkt.

Die US 2012/0150503 A1 zeigt einen Batterieemulator, bei welchem eine Zellanordnung durch ein Computermodell simuliert wird. Die WO 2006/054066 A1 offenbart eine Vorrichtung und ein Verfahren zum Ermitteln des Ladezustands einer Batterie. Yongjun Yuan et al.: "Assessment of power consumption control strategy for battery management system using hardware-in-the-loop simulation", Vehicle Power and Propulsion Conference, 2008. VPPC '08. IEEE, IEEE, Piscataway, NJ, USA, 3. September 2008, Seiten 1-6 zeigt eine Leistungsanalyse eines Batteriemanagementsystems.

Es ist daher eine Aufgabe der gegenständlichen Erfindung, bei einer Energiespeicheremulation einerseits die Genauigkeit der Energiespeicheremulation zu erhöhen und andererseits die oben beschriebenen Probleme mit Energiespeichermodellen zu beheben und dabei trotzdem flexibel in den Möglichkeiten der Emulation eines Energiespeichers zu bleiben.

Diese Aufgabe wird erfindungsgemäß dadurch gelöst, dass eine Laststromanforderung an den Energiespeicher anhand der Konfiguration des Energiespeichers in einen Zelltester-Laststrom einer realen Referenzzelle umgerechnet wird und die reale Referenzzelle mit dem Zelltester-Laststrom belastet wird und dabei die Zellspannung der Referenzzelle gemessen wird und die Zellspannung der Referenzzelle anhand der Konfiguration des Energiespeichers in eine erste Energiespeicherspannung umgerechnet wird, aus dem Energiespeichermodell und der Laststromanforderung eine zweite Energiespeicherspannung berechnet wird und die erste Energiespeicherspannung mit der zweiten Energiespeicherspannung verglichen wird und das Energiespeichermodell angepasst wird, wenn die erste Energiespeicherspannung um einen vorgegebenen Toleranzbereich von der zweiten Energiespeicherspannung abweicht. Das ermöglicht es, das Energiespeichermodell bedarfsweise anzupassen und so über den gesamten Betriebsbereich des Energiespeichers eine ausreichende Genauigkeit sicherzustellen. Da dabei verschiedenste Energiespeichermodelle genutzt werden können, bleibt das Verfahren damit ausreichend flexibel, um unterschiedlichste Energiespeicheremulationen durchführen zu können. Außerdem wird damit sichergestellt, dass der Zeitpunkt, wann das Energiespeichermodell angepasst wird, richtig ist, d.h. immer dann, wenn der Fehler zwischen Modell und Realität zu groß wird. Somit kann auch unmittelbar Einfluss auf die Genauigkeit der Energiespeicheremulation genommen werden. Insbesondere kann dasEnergiespeichermodell mittels einer Anzahl von Referenzzellen, z.B. mit verschiedenen SoC und/oder Temperaturzuständen, auch vor und auch während eines Prüflaufs kalibriert bzw. nachjustiert werden, oder überhaupt erst ermittelt werden.

Das Energiespeichermodell kann sehr einfach angepasst werden, wenn aus einem Messwert der Referenzzelle ein Modellparameter des Energiespeichermodells neu berechnet wird. Da im Zuge der Energiespeicheremulation ohnehin Messwerte an einer Referenzzelle erfasst werden, können diese vorteilhafterweise für die Anpassung herangezogen werden.

Wenn das Energiespeichermodell als elektrisches Modell vorliegt, kann die Anpassung sehr einfach dadurch erfolgen, indem ein Messwert der Referenzzelle, z.B. die Leelaufspannung, anhand der Konfiguration des Energiespeichers auf einen Modellparameter des Energiespeichermodells hochgerechnet wird. Hierbei kann vorteilhafterweise so vorgegangen werden, indem die Leerlaufspannung der Referenzzelle gemessen und anhand der Konfiguration des Energiespeichers auf die Leerlaufspannung des Energiespeichers als Modellparameter hochgerechnet wird, der Zelltester-Laststrom anhand der Konfiguration des Energiespeichers auf den Energiespeicher hochgerechnet wird und mit der Energiespeicherspannung aus der Beziehung

$$R_0 = \frac{(U_{OCB} - U_B)}{I_{ZB}}$$ ein Innenwiderstand des Energiespeichers als Modellparameter berechnet wird.

Wenn das Energiespeichermodell als mathematisches Modell vorliegt kann dieses einfach angepasst werden, indem ein neuer Modellparameter des Energiespeichermodells aus einer mathematischen Optimierung berechnet wird. Solche mathematischen Modelle und Optimierungsverfahren sind hinreichend bekannt und einfach umsetzbar.

Eine weitere vorteilhafte Art der Anpassung ergibt sich dadurch, dass ein anderes Energiespeichermodell geladen wird. Damit können für verschiedene Betriebsbereiche des Energiespeichers verschiedene Energiespeichermodelle verwendet werden, die den jeweiligen Bereich am besten widerspiegeln. Hier kann auch vorgesehen sein, dass die Bereiche vorab festgelegt sind und den Bereichen vorab verschiedene Energiespeichermodelle zugewiesen sind, was die Anpassung vereinfacht.

Ebenso kann vorteilhafterweise vorgesehen sein, dass der Vergleich der ersten Energiespeicherspannung mit der zweiten Energiespeicherspannung und in Abhängigkeit davon eine Anpassung des Energiespeichermodells durchgeführt wird, wenn ein vorgegebener Betriebspunkt des Energiespeichers erreicht wird. Damit kann zusätzlich eine Überprüfung der Genauigkeit des Energiespeichermodells erzwungen werden und das Energiespeichermodell angepasst werden, bevor die Abweichung zwischen Modell und Realität zu groß wird, was die Genauigkeit der Energiespeicheremulation erhöhen kann.

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt

Fig.1 eine schematische Darstellung einer Prüfstandanordnung mit erfindungsgemäßer Energiespeicher emulation,
Fig.2 eine schematische Darstellung einer typischen Konfiguration eines Energiespeichers
Fig.3 ein Beispiel eines Prüflings, der vom Energiespeicheremulator mit elektrischer Leistung versorgt wird und
Fig.4 ein einfaches elektrisches Energiespeichermodell.

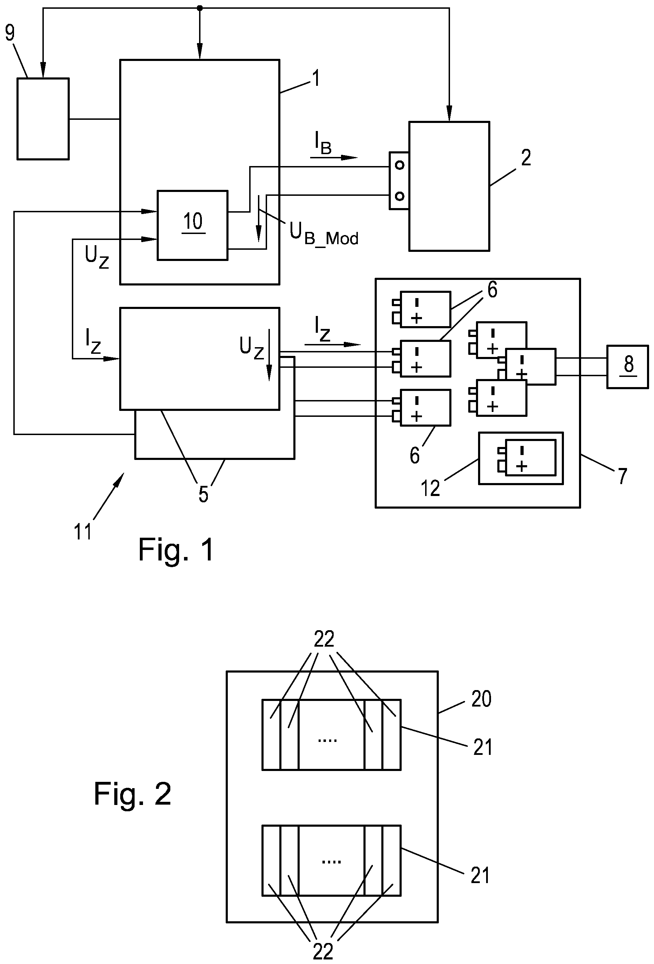

In Fig.1 ist eine Prüfstandanordnung 11 für einen elektrischen Antriebsstrang, z.B. eines Elektro- oder Hybridfahrzeuges, als Prüfling 2 dargestellt, wobei der reale elektrische Energiespeicher 20 zur elektrischen Versorgung des Prüflings 2 mittels eines Energiespeicheremulators 1 emuliert wird. Solche Prüfstandanordnungen 11 werden z.B. bei der Entwicklung von elektrischen Energiespeichern oder elektrischen Antriebssträngen verwendet.

Ein elektrischer Energiespeicher 20, wie in Fig.2 schematisch dargestellt, kann z.B. eine Batterie, eine Brennstoffzelle, ein SuperCap oder ähnliches sein. Eine Zelle 22 ist die kleinste elektrische Einheit eines elektrischen Energiespeichers 20. Ein Modul 21 besteht aus einer Anzahl von Zellen 22 und ein Energiespeicher 20 kann eine Anzahl von Modulen 21 und/oder Zellen 22 aufweisen. Die Zellen 22 und Module 21 können dabei beliebig seriell und/oder parallel miteinander verschaltet sein. Die Konfiguration eines elektrischen Energiespeichers 20 wird dabei auch häufig in der Art xSyP angegeben, wobei x die Anzahl der seriellen Zellen 21 und y die Anzahl der parallelen Module 21 angibt. Die Bezeichnung 100S2P bezeichnet somit einen Energiespeicher bestehend aus zwei parallelen Modulen 21, die wiederum aus jeweils hundert seriell verschalteten Zellen 22 bestehen.

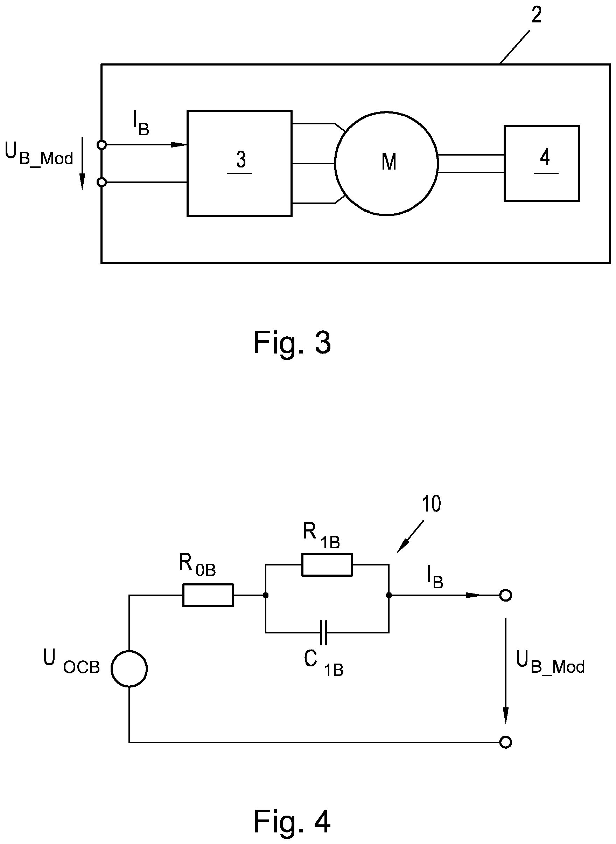

In Fig.3 ist beispielhaft als Prüfling 2 ein elektrischer Antriebsstrang dargestellt, mit einem Elektromotor M, der von einem Umrichter 3 versorgt wird und der eine Last 4 antreibt. Als Last 4 kommt auch eine geregelte Belastungsmaschine (z.B. in Form eines Elektromotors, ein sogenannten Dynamometer) in Frage, um verschiedene Lastzustände vorgeben zu können. Selbstverständlich sind beliebig andere Konfigurationen als Prüfling 2 denkbar. Der Prüfling 2 gibt im realen Betrieb eine Laststromanforderung, bzw. gleichwertig dazu eine Leistungsanforderung, an den Energiespeicher 20 (hier z.B.

eine Batterie) vor, z.B. durch ein vorgegebenes nachzufahrendes Fahrprofil für den Antriebsstrang, die einen Laststrom $I_B$ bewirkt, der zu einer Energiespeicherspannung $U_B$ führt. Dieses Verhalten eines realen Energiespeichers 20 soll durch den Energiespeicheremulator 1 mit Hilfe eines Energiespeichermodells 10 möglichst genau nachgebildet werden.

Zur Emulation des elektrischen Energiespeichers 20 ist im Ausführungsbeispiel nach Fig.1 im Energiespeicheremulator 1 ein Energiespeichermodell 10 implementiert, das in bekannter Weise aus einem Laststrom $I_B$ die Spannung des Energiespeichers $U_{B\_Mod}$ ermittelt, die an den Ausgang des Energiespeicheremulators 1 angelegt wird. Solche Energiespeichermodelle 10 sind hinlänglich bekannt und umfassen eine Anzahl von Parametern, die das Verhalten des Energiespeichers beschreiben. Ein einfaches elektrisches Energiespeichermodell 10 für eine Batterie, wie in Fig.4 dargestellt, besteht aus einer Serienschaltung einer Spannungsquelle $U_{OCB}$ für die Leerlaufspannung, einem RC-Kreis aus parallel geschalteten Widerstand $R_{1B}$ und Kapazität $C_{1B}$ und einem weiteren Widerstand $R_{0B}$. Im einfachsten Fall kann das Energiespeichermodell 10 auch nur aus einer Serienschaltung einer Spannungsquelle $U_{OCB}$ und eines Widerstandes $R_{0B}$ bestehen. Ebenso ist es denkbar, dass im Energiespeichermodell 10 auch noch weitere RC-Kreise, z.B. aus parallel geschalteten Widerstand $R_{2B}$ und Kapazität $C_{2B}$, enthalten sind. Solche elektrischen Energiespeichermodelle 10 sind hinreichend bekannt, weshalb hier nicht weiter eingegangen wird. Selbstverständlich sind auch komplexere Energiespeichermodelle 10 denkbar. Bei der Kalibrierung des Energiespeichermodells 10 werden die Modellparameter, hier z.B. Spannung $U_{OCB}$, Widerstände $R_{0B}$, $R_{1B}$ und Kapazität $C_{1B}$, mit konkreten Werten versehen. In der Regel in Form von Kennfeldern, in denen die Modellparameter in Abhängigkeit von Zustandsgrößen des Energiespeichers, z.B. die Temperatur T und der SoC (State of Charge), festgelegt sind, z.B. $U_{OC}=f(T, SoC)$, $R0=f(T, SoC)$. Ebenso können die Modellparameter für Laden und Entladen mit unterschiedlichen Werten hinterlegt sein, um das unterschiedliche Lade- und Entladeverhalten eines Energiespeichers abzubilden. Die Kalibrierung kann dabei durch entsprechende Messungen an einer Zelle 22 des Energiespeichers 20 oder einem Modul 21 des Energiespeichers 20 erfolgen. Das Energiespeichermodell 10 kann auch Teilmodelle für einzelnen Zellen 22 oder Module 21 aufweisen, um unterschiedliche Zellzustände im Energiespeicher 20 abbilden zu können.

Weiters ist in der Prüfstandanordnung 11 zumindest eine Referenzzelle 6 vorhanden, die mit einem Zelltester 5 verbunden ist. Als Referenzzelle 6 wird hier auch eine Gruppe von seriell und/oder parallel verschalteten einzelnen Zellen oder Modulen verstanden. Zelltester 5 sind an sich hinlänglich bekannte elektrische Schaltungen, die an eine Zelle, ein Modul oder einen Energiespeicher angeschlossen werden und der angeschlossenen Komponente einen Laststrom (Laden, Entladen), oder gleichwertig eine Leistungsanforderung (Laden, Entladen), aufprägen und dabei die Zellspannung $U_Z$, als Reaktion auf den eingeprägten Laststrom, erfassen. Ein solcher Zelltester 5 geht z.B. aus der AT 511 890 A1 hervor. Der Zelltester 5 kann auch noch andere Parameter der Referenzzelle 6, wie z.B. Temperatur, SoC oder SoH (State of Health), erfassen bzw. in bekannter Weise aus anderen Messgrößen berechnen.

Der dargestellte Aufbau mit Zelltester 5 und Referenzzellen 6 muss nicht fest mit dem Energiespeicheremulator 1 verbunden sein, sondern kann auch mobil und auch nur bei Bedarf eingesetzt werden.

Die Referenzzelle 6 wird hier verwendet, um die Abweichung des Energiespeichermodells 10 von einer realen Referenzzelle 6 zu bestimmen. Dazu wird zuerst die erfasst Zellspannung $U_Z$ z.B. wie nachfolgend beschrieben auf eine Energiespeicherspannung $U_B$ umgerechnet. Das Energiespeichermodell 10 emuliert z.B. einen elektrischer Energiespeicher 20 vom Typ 100S2P aus LiFePo4 (Lithium-Eisenphosphat) Zellen mit 20Ah und 3,3VDC Nennstrom- und Nennspannung, also 40Ah und 330VDC für den Energiespeicher 20. Wird im Prüflauf, z.B. durch das Prüfstandsautomatisierungssystem 9, nun ein Laststrom $I_B$ von 80A vorgegeben, z.B. um den Elektromotor M zu beschleunigen, so wird im Energiespeicheremulator 1 diese Anforderung aus der Energiespeicherkonfiguration, z.B. 100S2P, auf einen Zelltester-Laststrom $I_Z$ einer einzelnen elektrischen Einheit des Energiespeichers 20, z.B. eine Zelle 21 oder ein Modul 22 oder eine Kombination daraus, heruntergerechnet und die am Zelltester 5 angeschlossene Referenzzelle 6 mit diesem Zelltester-Laststrom $I_Z$ belastet. Ein Laststrom von 80A würde daher bei der angeführten Konfiguration des Energiespeichers 20 auf einen Zelltester-Laststrom $I_Z$=40A für eine Zelle 22 oder ein Modul 21 des Energiespeichers 20 heruntergerechnet werden. Die Konfiguration der Referenzzelle 6 (aus Zellen und Modulen) entspricht dabei der Konfiguration der elektrischen Einheit auf die heruntergerechnet wird. Im einfachsten Fall wird auf eine einzelne Zelle 22 des Energiespeichers 20 heruntergerechnet und die Referenzzelle 6 ist eine einzelne reale Zelle 22 des Energiespeichers 20. Anstelle des Laststromes $I_B$ könnte gleichwertig auch eine Leistung P vorgegeben werden. Die Reaktion der Referenzzelle 6 in Form der Zellspannung $U_Z$, z.B. 3,15VDC, wird vom Zelltester 5 erfasst und an den Energiespeicheremulator 1 geliefert. Der Energiespeicheremulator 1 rechnet die erhaltene Zellspannung $U_Z$ anhand der Energiespeicherkonfiguration, z.B. 100S2P, in eine Energiespeicherspannung $U_B$, hier z.B. 315VDC, um. In diesem Zuge können in an sich bekannter Weise auch andere Parameter des Energiespeichers 20, wie SoC oder SoH, ermittelt werden, z.B. vom Zelltester 5 oder vom Energiespeicheremulator 1. Das funktioniert natürlich auch für den Fall des Ladens des elektrischen Energiespeichers 20, z.B. durch Rekuperation. In diesem Fall wird die Referenzzelle 6 in Abhängigkeit vom Laststrom $I_B$ durch den Zelltester 5 mit einem Zelltester-Laststrom $I_Z$ geladen. Die reale Referenzzelle 6 ist damit ein Spiegelbild des Zustandes und der Reaktion eines realen Energiespeichers 20.

Auch ist es natürlich denkbar, das Energiespeichermodell 10 aus verschiedenen Referenzzellen 6 bzw. Zelltestern 5 zu versorgen, wie in Fig. 1 angedeutet, um z.B. Energiespeicher 20 mit fehlerhaften oder unausgeglichenen Zellen zu emulieren. Das Energiespeichermodell 10 kann dabei beispielsweise auch aus mehreren (Teil)Modellen, z.B. wie in Fig.4 dargestellt, bestehen.

Die derart ermittelte Energiespeicherspannung $U_B$ wird nun mit der vom Energiespeichermodell 10 aus derselben Leistungsanforderung berechneten Energiespeicherspannung $U_{B\_Mod}$ verglichen. Liegt die berechnete Energiespeicherspannung $U_{B\_Mod}$ innerhalb eines vorgegebenen Toleranzbereichs TB um die ermittelte Energiespeicherspannung $U_B$, gilt also $|U_{B\_Mod}-U_B|<TB$, wird die berechnete Energiespeicherspannung $U_{B\_Mod}$ vom Energiespeicheremulator 1 erzeugt und an den Prüfling 2 geschaltet.

Liegt die berechnete Energiespeicherspannung $U_{B\_Mod}$ außerhalb des Toleranzbereichs, so wird das Energiespeichermodell 10 im Energiespeicheremulator 1 angepasst, um die Qualität der Emulation aufrecht zu erhalten. Das Anpassen erfolgt beispielsweise derart, dass aus aktuellen Messwerten der Referenzzelle 6, z.B. Zellspannung $U_Z$, Temperatur, etc., zumindest ein benötigter Modellparameter, z.B. Leerlaufspannung $U_{OCB}$, Widerstände $R_{0B}$, $R_{1B}$ und Kapazität $C_{1B}$, berechnet wird oder der Modellparameter an der Referenzzelle 6 gemessen und auf den Energiespeicher hochgerechnet wird, um die berechnete Energiespeicherspannung $U_{B\_Mod}$ innerhalb des Toleranzbereichs TB zu bringen. Je nach Art des Energiespeichermodells 10 kann hier unterschiedlich vorgegangen werden.

Im Fall eines sehr einfachen elektrischen Energiespeichermodells 10 mit einer Serienschaltung einer Spannungsquelle der Leerlaufspannung $U_{OCB}$ und eines Widerstandes $R_{0B}$ (der Innenwiderstand des Energiespeichers) könnte z.B. wie folgt vorgegangen werden. Zuerst wird eine passende Referenzzelle 6 des Energiespeichers ausgewählt, die dem aktuellen Betriebspunkt am besten entspricht. Ist der aktuelle Betriebspunkt des Energiespeichers z.B. 20% SoC bei einer Temperatur T von 25°C, dann wird vorzugsweise eine Referenzzelle 6 herangezogen, die ebenfalls diesen Betriebspunkt aufweist. Ist eine solche nicht vorhanden, dann wird eine Referenzzelle 6 genommen, die diesem Betriebspunkt am nächsten kommt. Der Zelltester 5 misst dann an dieser Referenzzelle 6 die Leerlaufspannung $U_{OC}$ der Referenzzelle 6, d.h. die Ausgangsspannung der unbelasteten Referenzzelle 6, die dann wie oben beschrieben auf die Leerlaufspannung $U_{OCB}$ des Energiespeichers hochgerechnet wird. Danach legt der Zelltester 5 den aktuellen Zelltester-Laststrom $I_Z$ an die Referenzzelle 6 an und misst die Reaktion in Form der Ausgangsspannung $U_Z$ der Referenzzelle 6, die wieder auf die Energiespeicherspannung $U_B$ des Energiespeichers hochgerechnet wird. Der Zelltester-Laststrom $I_Z$ wird ebenfalls auf den Energiespeicher hochgerechnet ($I_{ZB}$). Daraus kann dann aus dem Zusammenhang

$$R_0 = \frac{(U_{OCB} - U_B)}{I_{ZB}}$$ der Innenwiderstand $R_0$ des Energiespeichers berechnet werden. Die derart ermittelten Modellparameter des Energiespeichermodells des Energiespeichers, hier die Leerlaufspannung $U_{OCB}$ und der Innenwiderstand $R_{0B}$, werden dann in den zugrunde liegenden Kennfeldern an der Stelle des aktuellen Betriebspunktes aktualisiert, in dem die Werte an dieser Stützstelle (gegeben durch den Betriebspunkt) durch die neu ermittelten ersetzt werden. Gibt es für den aktuellen Betriebspunkt keine entsprechende Stützstelle im Kennfeld, dann kann entweder eine neue Stützstelle für diesen aktuellen Betriebspunkt angelegt werden, oder es wird auf die nächstliegende vorhandene Stützstelle interpoliert.

Liegt das Energiespeichermodell 10 in Form eines mathematischen Modells vor, z.B. in Form einer Funktion $U_B=f(I_B, T, SoC, ...)$, eines neuronalen Netzwerkes, eines Local Model Network (LMN) oder eines Multilayer Perceptron (MLP), dann können die neuen Modellparameter des mathematischen Modells (z.B. in Form von Koeffizienten des Modells) aus einer mathematischen Optimierung hervorgehen, indem der Fehler zwischen den beiden ermittelten Energiespeicherspannungen minimiert wird.

Alternativ, oder auch zusätzlich, kann auch ein anderes Energiespeichermodell 10 geladen werden, z.B. in Abhängigkeit vom aktuellen Betriebspunkt, z.B. gegeben durch SoC, SoH (State of Health) oder der Temperatur. Hierzu können verschiedene Energiespeichermodelle 10 hinterlegt sein, z.B. im Energiespeicheremulator 1 oder im Prüfstandautomatisierungssystem 9, aus denen dann das am besten geeignetste, d.h. jenes mit dem kleinsten Fehler hinsichtlich der an der Referenzzelle 6 gemessenen Ausgangsspannung $U_Z$, ausgewählt wird. Gegebenenfalls kann das neu ausgewählte Energiespeichermodell 10 auch entsprechend kalibriert werden. Ebenso ist es denkbar, für verschiedene Betriebspunktebereiche verschiedene Energiespeichermodelle 10 vorab vorzugeben.

Die Anpassung erfolgt dabei vorzugsweise immer so, dass der Fehler zwischen der aus dem Energiespeichermodell berechneten Energiespeicherspannung $U_{B\_Mod}$ und der anhand der Messung an der Referenzzelle 6 ermittelten Energiespeicherspannung $U_B$ zumindest innerhalb des vorgegebenen Toleranzbereichs TB liegt, vorzugsweise aber minimiert wird.

Die Überprüfung der Genauigkeit des Energiespeichermodells 10 kann aber auch an vorgegebenen Betriebspunkten erfolgen, beispielsweise immer dann wenn der SoC bestimmte Punkte passiert, wie z.B. bei SoC gleich 0, 10, 20, 30, 40, ..., 80, 90, 100. Hierzu werden genauso viele Referenzzellen 6 mit den entsprechenden SoC-Werten vorrätig gehalten, die auch gemäß dem emulierten Energiespeicher temperiert werden. Wird während des Prüflaufs einer der vorgegebenen Betriebspunkte (hier in Form der SoC-Werte) passiert, erfolgt eine Überprüfung der Genauigkeit des Energiespeichermodells 10 wie oben beschrieben. Dabei kann auch ein anderer Toleranzbereich TB vorgegeben sein. Liegt die Genauigkeit außerhalb des Toleranzbereichs TB, dann erfolgt wiederum eine Anpassung des Energiespeichermodells 10 wie oben beschrieben.

Das Anpassen des Energiespeichermodells 10 kann manuell erfolgen oder bevorzugt automatisiert durch entsprechende Algorithmen im Energiespeicheremulator 1. Je nach Art des Energiespeichermodells 10, z.B. ein elektro-chemisches, ein elektrisches oder ein mathematisches Modell, können hierfür verschiedene Modellparameter angepasst werden. Auf diese Weise kann ein bestehendes Energiespeichermodell 10 einfach parametrisiert bzw. kalibriert werden, oder die Modellparameter auf einfache Weise nachgeführt werden, z.B. bei Alterung der Referenzzelle 6, ohne das unmittelbar in der Struktur des Energiespeichermodells 10 abbilden zu müssen. Dadurch können auch einfachere Energiespeichermodelle 10 im Energiespeicheremulator 1 verwendet werden.

Vorteilhaft wird ein Pool 7 von Referenzzellen 6 vorrätig gehalten. Z.B. Referenzzellen unterschiedlichsten Typs oder unterschiedlichster Zustände (SoC, SoH, Temperatur). Die Referenzzellen 6 können natürlich auch durch den Zelltester 5 oder durch externe Ladegeräte 8 vorbereitet bzw. vorkonditioniert werden, z.B. in dem eine Referenzzelle 6 durch verschiedene Lastzyklen warmgefahren wird. Mit dem Warmfahren können insbesondere realistischere Temperaturverteilungen emuliert werden, als das mit einer externen Temperierung der Referenzzelle 6, z.B. in einer Klimakammer 12, möglich wäre. Durch Auswahl der jeweils richtigen Referenzzelle(n) 6 (Typ, Betriebspunkt) kann der gewünschte Energiespeicher auf einfachste Weise emuliert werden.

Eine mit einem Zelltester 5 verbundene Zelle 6 des Energiespeichers kann dabei auch in einer hinlänglich bekannten Klimakammer 12 angeordnet werden, um zusätzlich noch äußere Umgebungsbedingungen, wie z.B. Umgebungstemperatur, Luftfeuchtigkeit, etc., simulieren zu können.

## Patentansprüche

1. Energiespeicheremulator mit einem Energiespeichermodell (10) zur Emulation eines elektrischen Energiespeichers (20) bestehend aus einer Anzahl von Zellen (22) und mit zumindest einer realen Referenzzelle (6), die über einen Zelltester (5) mit dem Energiespeicheremulator (1) verbunden ist, **da-**

**durch gekennzeichnet, dass** der Energiespeicheremulator (1) ausgestaltet ist, eine elektrische Laststromanforderung an den elektrischen Energiespeicher (20) anhand der Konfiguration des Energiespeichers (20) in eine Laststromanforderung an die reale Referenzzelle (6) umzurechnen und über den Zelltester (5) in Form eines Zelltester-Laststromes $(I_Z)$ an die reale Referenzzelle (6) anzulegen, und der Zelltester (5) ausgestaltet ist, die Zellspannung $(U_Z)$ der Referenzzelle (6) als Reaktion auf den Zelltester-Laststrom $(I_Z)$ zu erfassen und an den Energiespeicheremulator (1) zu übergeben, wobei der Energiespeicheremulator (1) ausgestaltet ist, die Zellspannung $(U_Z)$ der realen Referenzzelle (6) anhand der Konfiguration des Energiespeichers (20) in eine erste Energiespeicherspannung $(U_B)$ umzurechnen und anhand des Energiespeichermodells (10) aus der elektrischen Laststromanforderung eine zweite Energiespeicherspannung $(U_{B\_Mod})$ zu berechnen, **und dass** der Energiespeicheremulator (1) ausgestaltet ist, die erste Energiespeicherspannung $(U_B)$ und die zweite Energiespeicherspannung $(U_{B\_Mod})$ zu vergleichen und das Energiespeichermodell (10) anzupassen, wenn die erste Energiespeicherspannung $(U_B)$ um einen vorgegebenen Toleranzbereich (TB) von der zweiten Energiespeicherspannung $(U_{B\_Mod})$ abweicht.

2. Verfahren zur Energiespeicheremulation mit dem ein elektrischer Energiespeicher (20) mittels eines Energiespeicheremulators (1) und einem darin implementierten Energiespeichermodells (10) emuliert wird, **dadurch gekennzeichnet, dass** eine Laststromanforderung an den Energiespeicher (20) anhand der Konfiguration des Energiespeichers (20) in einen Zelltester-Laststrom $(I_Z)$ einer realen Referenzzelle (6) umgerechnet wird und die reale Referenzzelle (6) mit dem Zelltester-Laststrom $(I_Z)$ belastet wird und dabei die Zellspannung $(U_Z)$ der realen Referenzzelle (6) gemessen wird und die Zellspannung $(U_Z)$ der realen Referenzzelle (6) anhand der Konfiguration des Energiespeichers (20) in eine erste Energiespeicherspannung $(U_B)$ umgerechnet wird, **dass** aus dem Energiespeichermodell (10) und der Laststromanforderung eine zweite Energiespeicherspannung $(U_{B\_Mod})$ berechnet wird **und dass** die erste Energiespeicherspannung $(U_B)$ mit der zweiten Energiespeicherspannung $(U_{B\_Mod})$ verglichen wird und das Energiespeichermodell (10) angepasst wird, wenn die erste Energiespeicherspannung $(U_B)$ um einen vorgegebenen Toleranzbereich (TB) von der zweiten Energiespeicherspannung $(U_{B\_Mod})$ abweicht.

3. Verfahren nach Anspruch 2, **dadurch gekennzeichnet, dass** das Energiespeichermodell (10) angepasst wird, indem aus einem Messwert der realen Referenzzelle (6) ein Modellparameter des Energiespeichermodells (10) neu berechnet wird.

4. Verfahren nach Anspruch 2, **dadurch gekennzeichnet, dass** das Energiespeichermodell (10) als elektrisches Modell vorliegt und angepasst wird, indem ein Messwert der realen Referenzzelle (6) anhand der Konfiguration des Energiespeichers (20) auf einen Modellparameter ($U_{OCB}$, $R_{0B}$, $R_{1B}$, $C_{1B}$) des Energiespeichermodells (10) hochgerechnet wird.

5. Verfahren nach Anspruch 4, **dadurch gekennzeichnet, dass** die Leerlaufspannung ($U_{OC}$) der realen Referenzzelle (6) gemessen und anhand der Konfiguration des Energiespeichers (20) auf die Leerlaufspannung ($U_{OCB}$) des Energiespeichers (20) als Modellparameter hochgerechnet wird, der Zelltester-Laststrom ($I_Z$) anhand der Konfiguration des Energiespeichers (20) auf den Energiespeicher (20) hochgerechnet wird und mit der Energiespeicherspannung ($U_B$) aus der Beziehung

$$R_0 = \frac{(U_{OCB} - U_B)}{I_{ZB}}$$

ein Innenwiderstand ($R_{0B}$) des Energiespeichers (20) als Modellparameter berechnet wird.

6. Verfahren nach Anspruch 2, **dadurch gekennzeichnet, dass** das Energiespeichermodell (10) als mathematisches Modell vorliegt und angepasst wird, indem ein neuer Modellparameter des Energiespeichermodells aus einer mathematischen Optimierung berechnet wird.

7. Verfahren nach Anspruch 2, **dadurch gekennzeichnet, dass** das Energiespeichermodell (10) angepasst wird, indem ein anderes Energiespeichermodell geladen wird.

8. Verfahren nach einem der Ansprüche 2 bis 7, **dadurch gekennzeichnet, dass** der Vergleich der ersten Energiespeicherspannung ($U_B$) mit der zweiten Energiespeicherspannung ($U_{B\_Mod}$) und in Abhängigkeit davon eine Anpassung des Energiespeichermodells (10) durchgeführt wird, wenn ein vorgegebener Betriebspunkt des Energiespeichers (20) erreicht wird.

**Claims**

1. Energy accumulator emulator having an energy accumulator model (10) for emulation of an electrical energy accumulator (20) consisting of a plurality of cells (22) and having at least one real reference cell (6) which is connected by means of a cell tester (5) to the energy accumulator emulator (1), **characterized in that** the energy accumulator emulator (1) is configured to convert an electrical load current demand on the electrical energy accumulator (20) to a load current demand on the real reference cell (6) on the basis of the configuration of the energy accumulator (20), and to apply it to the real reference cell (6) by means of the cell tester (5) in the form of a cell tester load current ($I_Z$), and the cell tester (5) is configured to detect the cell voltage ($U_Z$) of the real reference cell (6) in response to the cell tester load current ($I_Z$) and to supply it to the energy accumulator emulator (1), wherein the energy accumulator emulator (1) is configured to convert the cell voltage ($U_Z$) of the real reference cell (6) into a first energy accumulator voltage ($U_B$) on the basis of the configuration of the energy accumulator (20), and to calculate a second energy accumulator voltage ($U_{B\_Mod}$) from the electrical load current demand on the basis of the energy accumulator model (10), **and that** the energy accumulator emulator (1) is configured to compare the first energy accumulator voltage ($U_B$) and the second energy accumulator voltage ($U_{B\_Mod}$) and to adapt the energy accumulator model (10) if the first energy accumulator voltage ($U_B$) deviates by a predetermined tolerance range (TB) from the second energy accumulator voltage ($U_{B\_Mod}$).

2. A method for energy accumulator emulation by which an electrical energy accumulator (20) is emulated by means of an energy accumulator emulator (1) and an energy accumulator model (10) implemented therein, **characterized in that** a load current demand on the energy accumulator (20) is converted to a cell tester load current ($I_Z$) of a real reference cell (6) based on the configuration of the energy accumulator (20) and the cell tester load current is applied to the real reference cell (6), and thereby the cell voltage ($U_Z$) of the real reference cell (6) is measured and the cell voltage ($U_Z$) of the real reference cell (6) is converted to a first energy accumulator voltage ($U_B$) based on the configuration of the energy accumulator (20), **in that** a second energy accumulator voltage ($U_{B\_Mod}$) is calculated from the energy accumulator model (10) and the load current demand, **and in that** the first energy accumulator voltage ($U_B$) is compared to the second energy accumulator voltage ($U_{B\_Mod}$) and the energy accumulator model (10) is adjusted if the first energy accumulator voltage ($U_B$) deviates by a specified tolerance range (TB) from the second energy accumulator voltage ($U_{B\_Mod}$).

3. The method according to claim 2, **characterized in that** the energy accumulator model (10) is adapted, **in that** a model parameter of the energy accumulator (10) is newly calculated from a measured value of the real reference cell (6).

**4.** The method according to claim 2, **characterized in that** the energy accumulator model (10) is present as an electrical model and is adapted **in that** a measured value of the real reference cell (6) is extrapolated to a model parameter ($U_{OCB}$, $R_{0B}$, $R_{1B}$, $C_{1B}$) of the energy accumulator model (10) on the basis of the configuration of the energy accumulator (20).

**5.** The method according to claim 4, **characterized in that** the open circuit voltage ($U_{OC}$) of the real reference cell (6) is measured and is extrapolated to the open circuit voltage ($U_{OCB}$) of the energy accumulator (20) as model parameter on the basis of the configuration of the energy accumulator (20), the cell tester load current ($I_Z$) is extrapolated to the energy accumulator (20) on the basis of the configuration of the energy accumulator (20) and an internal resistance($R_{0B}$) of the energy accumulator (20) is calculated as a model parameter by means of the energy accumulator voltage ($U_B$) by using the relationship

$$R_0 = \frac{(U_{OCB} - U_B)}{I_{ZB}} \quad .$$

**6.** The method according to claim 2, **characterized in that** the energy accumulator model (10) is present as a mathematical model and is adapted by calculation of a new model parameter of the energy accumulator model by using a mathematical optimization.

**7.** The method according to claim 2, **characterized in that** the energy accumulator model (10) is adapted, **in that** another energy accumulator model is charged.

**8.** The method according to one of claims 2 to 7, **characterized in that** the comparison of the first energy accumulator voltage ($U_B$) with the second energy accumulator voltage ($U_{B\_Mod}$) and adaptation of the energy accumulator model (10) as a function thereof is carried out if a predetermined operating point of the energy accumulator (20) is reached.

## Revendications

**1.** Émulateur d'accumulateur d'énergie comprenant un modèle d'accumulateur d'énergie (10) destiné à émuler un accumulateur d'énergie électrique (20) constitué d'un grand nombres de cellules (22) et d'au moins une cellule de référence réelle (6) qui est reliée à l'émulateur d'accumulateur d'énergie (1) par le biais d'un testeur de cellule (5), **caractérisé en ce que** l'émulateur d'accumulateur d'énergie (1) est conçu pour transformer une demande de courant de charge électrique au niveau de l'accumulateur d'énergie électrique (20) sur la base de la configuration de l'accumulateur d'énergie (20) en une demande de courant de charge au niveau de la cellule de référence réelle (6) et pour l'appliquer à la cellule de référence réelle (6) par le biais du testeur de cellule (5) sous la forme d'un courant de charge de testeur de cellule ($I_Z$), et le testeur de cellule (5) est conçu pour détecter la tension de cellule ($U_Z$) de la cellule de référence (6) en réaction au courant de charge de testeur de cellule ($I_Z$) et pour le transférer à l'émulateur d'accumulateur d'énergie (1), l'émulateur d'accumulateur d'énergie (1) étant configuré pour transformer la tension de cellule ($U_Z$) de la cellule de référence réelle (6) en une première tension d'accumulateur d'énergie ($U_B$) sur la base de la configuration de l'accumulateur d'énergie (20) et pour calculer une seconde tension d'accumulateur électrique ($U_{B\_Mod}$) à partir de la demande de courant électrique sur la base du modèle d'accumulateur d'énergie (10) et **en ce que** l'émulateur d'accumulateur d'énergie (1) est conçu pour comparer la première tension d'accumulateur d'énergie ($U_B$) et la seconde tension d'accumulateur d'énergie ($U_{B\_Mod}$) et pour adapter le modèle d'accumulateur d'énergie (10) lorsque la première tension d'accumulateur d'énergie ($U_B$) s'écarte de la seconde tension d'accumulateur d'énergie ($U_{B\_mod}$) d'une gamme de tolérances prédéterminée (TB).

**2.** Procédé d'émulation d'accumulateur d'énergie permettant d'émuler un accumulateur d'énergie électrique (20) au moyen d'un émulateur d'accumulateur d'énergie (1) et d'un modèle d'accumulateur d'énergie (10) mis en oeuvre à l'intérieur de celui-ci, **caractérisé en ce qu'**une demande de courant de charge au niveau de l'accumulateur d'énergie (20) est transformée en un courant de charge de testeur de cellule ($I_Z$) d'une cellule de référence réelle (6) sur la base de la configuration de l'accumulateur d'énergie (20) et la cellule de référence réelle (6) est alimentée avec le courant de charge de testeur de cellule ($I_Z$) pendant que la tension de cellule ($U_Z$) de la cellule de référence réelle (6) est mesurée et la tension de cellule ($U_Z$) de la cellule de référence réelle (6) est transformée (20) en une première tension d'accumulateur d'énergie ($U_B$) sur la base de la configuration de l'accumulateur d'énergie (20), **en ce qu'**une seconde tension d'accumulateur d'énergie ($U_{B\_Mod}$) est calculée à partir du modèle d'accumulateur d'énergie (10) et de la demande de courant de charge, et **en ce que** la première tension d'accumulateur d'énergie ($U_B$) est comparée à la seconde tension d'accumulateur d'énergie ($U_{B\_Mod}$) et le modèle d'accumulateur d'énergie (10) est adapté lorsque la première tension d'accumulateur d'énergie ($U_B$) s'écarte de la seconde tension d'accumulateur d'énergie ($U_{B\_Mod}$) d'une gamme de tolérances prédéterminée (TB).

3. Procédé selon la revendication 2, **caractérisé en ce que** le modèle d'accumulateur d'énergie (10) est adapté **en ce qu'**un paramètre du modèle d'accumulateur d'énergie (10) est recalculé à partir d'une valeur de mesure de la cellule de référence réelle (6).

4. Procédé selon la revendication 2, **caractérisé en ce que** le modèle d'accumulateur d'énergie (10) est présent sous la forme d'un modèle électrique et est ajusté par extrapolation d'une valeur de mesure de la cellule de référence réelle (6) à un paramètre de modèle ($U_{OCB}$, $R_{0B}$, $R_{1B}$, $C_{1B}$) du modèle d'accumulateur d'énergie (10) sur la base de la configuration de l'accumulateur d'énergie (20).

5. Procédé selon la revendication 4, **caractérisé en ce que** la tension en circuit ouvert ($U_{OC}$) de la cellule de référence réelle (6) est mesurée et est extrapolée à la tension en circuit ouvert ($U_{OCB}$) de l'accumulateur d'énergie (20) en tant que paramètre de modèle sur la base de la configuration de l'accumulateur d'énergie (20), le courant de charge de testeur de cellule ($I_Z$) est extrapolé à l'accumulateur d'énergie (20) sur la base de la configuration de l'accumulateur d'énergie (20) et une résistance interne ($R_{OB}$) de l'accumulateur d'énergie (20) est calculée comme paramètre de modèle avec la tension d'accumulateur d'énergie ($U_B$) à partir de la relation

$$R_0 = \frac{(U_{OCB} - U_B)}{I_Z}.$$

6. Procédé selon la revendication 2, **caractérisé en ce que** le modèle d'accumulateur d'énergie (10) est présent sous la forme d'un modèle mathématique et est adapté **en ce qu'**un nouveau paramètre du modèle d'accumulateur d'énergie est calculé à partir d'une optimisation mathématique.

7. Procédé selon la revendication 2, dans lequel le modèle d'accumulateur d'énergie (10) est adapté par chargement d'un autre modèle d'accumulateur d'énergie.

8. Procédé selon l'une des revendications 2 à 7, **caractérisé en ce que** la comparaison de la première tension d'accumulateur d'énergie ($U_B$) avec la seconde tension d'accumulateur d'énergie ($U_{B\_Mod}$) est effectuée et, en fonction de cette comparaison, une adaptation du modèle d'accumulateur d'énergie (10) est effectuée lorsqu'un point de fonctionnement prédéterminé de l'accumulateur d'énergie (20) est atteint.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- AT 510998 A2
- JP 2012047715 A
- US 20120150503 A1
- WO 2006054066 A1
- AT 511890 A1

**In der Beschreibung aufgeführte Nicht-Patentliteratur**

- Assessment of power consumption control strategy for battery management system using hardware-in-the-loop simulation. **YONGJUN YUAN et al.** Vehicle Power and Propulsion Conference, 2008. VPPC '08. IEEE. IEEE, 03. September 2008